(19) Europäisches Patentamt
European Patent Office
Office européen des brevets

(11) **EP 1 797 638 B1**

(12) **EUROPÄISCHE PATENTSCHRIFT**

(45) Veröffentlichungstag und Bekanntmachung des Hinweises auf die Patenterteilung:
**13.02.2008 Patentblatt 2008/07**

(21) Anmeldenummer: **05779260.8**

(22) Anmeldetag: **30.08.2005**

(51) Int Cl.:
*H03C 5/00* (2006.01)     *H03F 1/32* (2006.01)

(86) Internationale Anmeldenummer:
**PCT/EP2005/054257**

(87) Internationale Veröffentlichungsnummer:
**WO 2006/037701 (13.04.2006 Gazette 2006/15)**

(54) **"POLAR LOOP"-SCHALTUNGSANORDNUNG MIT VERZERRUNGSUNTERDRÜCKUNG UND VERFAHREN ZUR VERZERRUNGSUNTERDRÜCKUNG IN EINER "POLAR LOOP"-SCHALTUNGSANORDNUNG**

POLAR LOOP CIRCUIT ARRANGEMENT WITH DISTORTION SUPPRESSION AND METHOD FOR DISTORTION SUPPRESSION IN A POLAR LOOP CIRCUIT ARRANGEMENT

ENSEMBLE CIRCUIT EN 'BOUCLE POLAIRE ' AVEC ELIMINATION DE DISTORSIONS ET PROCEDE D'ELIMINATION DE DISTORSIONS DANS UN ENSEMBLE CIRCUIT EN 'BOUCLE POLAIRE'

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **06.10.2004 DE 102004048702**

(43) Veröffentlichungstag der Anmeldung:
**20.06.2007 Patentblatt 2007/25**

(73) Patentinhaber: **SIEMENS AKTIENGESELLSCHAFT**
**80333 München (DE)**

(72) Erfinder: **NAGEL, Jörg**
**80337 Munich (DE)**

(74) Vertreter: **Samson & Partner**
**Widenmayerstrasse 5**
**80538 München (DE)**

(56) Entgegenhaltungen:
**EP-A- 1 217 753      EP-A- 1 225 690**
**WO-A-02/47249**

EP 1 797 638 B1

**Beschreibung**

Die Erfindung betrifft eine "Polar Loop"-Schaltungsanordnung zur Erzeugung und Verstärkung von amplituden- und phasenmodulierten Signalen mit mindestens: einem Leistungsverstärker, einem Amplituden- und einem Phasenregelkreis, wobei mittels Amplituden- und Phasenregelkreis eine nach Amplitude und Phase getrennte Signalmodulation stattfindet und die Modulationssignale zur Signalverstärkung dem Eingang des Leistungsverstärkers zugeführt werden und zwischen Eingang und Ausgang des Leistungsverstärkers Signalverzerrungen, insbesondere in Form von "AM PM conversion", auftreten, die innerhalb einer Regelbandbreite von den Regelkreisen reduziert werden (siehe z.B das Dokument WO 02/47249 A).

Des weiteren betrifft die Erfindung ein Verfahren zur Erzeugung und Verstärkung von amplituden- und phasenmodulierten Signalen in einer "Polar Loop"-Schaltungsanordnung, bei dem mittels Amplituden- und Phasenregelkreis eine nach Amplitude und Phase getrennte Signalmodulation vorgenommen wird und die Modulationssignale danach in den Eingang eines Leistungsverstärkers eingespeist werden und im Leistungsverstärker die Signale verstärkt werden, wobei zwischen Eingang und Ausgang des Leistungsverstärkers Signalverzerrungen, insbesondere in Form von "AM PM conversion", auftreten, die teilweise von den Regelkreisen reduziert werden.

Für die Erzeugung und Verstärkung von amplituden- und phasenmodulierter Hochfrequenzsignale, zum Beispiel von Mobilfunksignalen, eignet sich besonders eine "Polar Loop"-Schaltungsanordnung, welche unter Nutzung von Regelkreisen, zum Beispiel eines Phasenregelkreises und eines Amplitudenregelkreises, eine gewünschte Signalmodulation präzise auf einen Hochfrequenzträger aufprägen kann. Dabei unterdrücken die Regelkreise innerhalb ihrer Regelbandbreite die Verzerrungen, die in dem Ausgangsverstärker der "Polar Loop"-Schaltungsanordnung auftreten. Der Grad dieser Unterdrückung wird von den Eigenschaften der Regelkreise bestimmt und kann nicht beliebig hoch eingestellt werden, da beispielsweise auch die Regelkreisstabilität und die Rauschanforderungen erfüllt sein müssen. Ausgangsverstärker, wie sie auch in Mobilfunkendgeräten nach dem GSM EDGE Standard (=Global System for Mobile communications Enhanced Data rates for GSM Evolution) eingesetzt werden, weisen eine Verzerrung auf, welche als "AM PM conversion" bekannt ist. Dabei ändert sich die Phasendifferenz $\Phi_e$ zwischen Hochfrequenzeingang und Hochfrequenzausgang des Verstärkers als Funktion der Amplitudensteuergröße. Durch diese Verzerrung wird dem Phasenregelkreis die Phasendifferenz $\Phi_e$ als Fehlersignal addiert, welches mit der Korrekturfähigkeit des Phasenregelkreises unterdrückt wird. Das durch die "AM PM conversion" erzeugte Fehlersignal ruft am Ausgang der "Polar Loop"-Schaltungsanordnung eine Fehlerphase $\Phi_x$ hervor. Die Eigenschaften hinsichtlich der "AM PM conversion" bei realen Verstärkern können beträchtliche Verzerrungen verursachen, welche die Korrekturfähigkeit der "Polar Loop"-Schaltungsanordnung übersteigen und somit eine Verschlechterung der Qualität des Ausgangssignals bewirken.

Um die negativen Auswirkungen der "AM PM conversion" zu minimieren, musste bisher der Phasenregelkreis eine möglichst hohe Regelverstärkung aufweisen beziehungsweise eine möglichst hohe Bandbreite besitzen. Hierdurch konnte der Effekt der "AM PM conversion" prinzipiell verringert werden, wobei gleichzeitig andere Parameter, wie Regelkreisstabilität und Rauscheigenschaften, äußert negativ beeinflusst wurden. Außerdem wurde die Minimierung der "AM PM conversion" im Verstärker selbst durch Einsatz von (Halbleiter-) Bauelementen mit besonderen Eigenschaften oder aufwendigen Schaltungsanordnungen erreicht. Diese Art der Minimierung der "AM PM conversion" ist aber hinsichtlich der Unterdrückungswirkung begrenzt und durch die hohen Bauteilanforderungen auch kostenintensiv. Auch die bisher zur Reduzierung der "AM PM conversion" verwendeten Kompensationsschaltungen erzeugen einen komplexeren Aufbau der Schaltungsanordnung und dadurch weitere Bauteilekosten.

Die bisher bekannten Lösungen zur Minimierung der "AM PM conversion" in einem Verstärker, insbesondere einem HF-Verstärker, sind nicht befriedigend, da diese zum einen eine zu geringe Unterdrückung der Verzerrung erreichen und zum anderen durch aufwendige Zusatzschaltungen und spezielle Bauteileauswahl meist auch sehr kostenaufwendig sind.

Es ist daher Aufgabe der Erfindung, eine neue Schaltungsanordnung und ein neues Verfahren zur Unterdrückung der "AM PM conversion" in einem Verstärker zur Verfügung zu stellen, die gegenüber den bekannten Schaltungsanordnungen und Verfahren eine bessere Unterdrückung der Verzerrung erreichen und dabei gleichzeitig mit geringerem Bauteileaufwand und somit geringeren Kosten auskommen.

Diese Aufgabe wird durch eine Schaltungsanordnung mit den Merkmalen des ersten Patentanspruches und ein Verfahren mit den Merkmalen des unabhängigen Patentanspruches 8 gelöst. Vorteilhafte Weiterbildungen der Erfindung sind Gegenstand untergeordneter Patentansprüche.

Der Erfinder hat erkannt, dass sich die zwischen dem Eingang und dem Ausgang eines Leistungsverstärkers in einer "Polar Loop"-Schaltungsanordnung auftretende "AM PM conversion" wesentlich reduzieren oder gar ganz unterdrücken lässt, wenn vor dem Eingang des Leistungsverstärkers mit einem einfachen Übertragungsglied aus dem Amplitudenregelkreis ein Korrektursignal abgeleitet wird und dieses dem Phasenregelkreis eingespeist wird.

Demgemäß schlägt der Erfinder vor, die bekannte "Polar Loop"-Schaltungsanordnung zur Erzeugung und Verstärkung von amplituden- und phasenmodulierten Signalen mit mindestens: einem Leistungsverstärker, einem Amplituden- und einem Phasenregelkreis, wobei im Amplituden- und Phasenregelkreis eine nach Amplitude und Phase getrennte Signalmodulation stattfindet und die modulierten Signale zur Signalverstärkung dem Eingang des Leistungsverstärkers zugeführt werden und zwischen Eingang und Ausgang des Leistungsverstärkers Signalverzerrungen, insbesondere in Form von "AM PM conversion", auftreten, die innerhalb einer Regelbandbreite von den Regelkreisen reduziert werden, dahingehend zu verbessern, dass zur weiteren Reduzierung von Signalverzerrungen vor dem Eingang des Leistungsverstärkers und zwischen Amplitudenregelkreis und Phasenregelkreis zumindest ein Übertragungsglied angeordnet ist, das aus dem Amplitudenregelkreis ein Korrektursignal ableitet und in den Phasenregelkreis einspeist.

Hierdurch können in den Leistungsverstärker bereits korrigierte Signale eingespeist werden, die an die Signalverzerrungscharakteristik des Leistungsverstärkers angepasst sind, so dass am Ausgang des Leistungsverstärkers unverzerrte verstärkte Signale zur Verfügung stehen. Da zur Signalübertragung ein einfaches Übertragungsglied, im wesentlichen ein einfaches (Halbleiter-)Bauteil, verwendet wird, sind die bisher notwendigen aufwändigen Zusatzschaltungen zur Kompensation der "AM PM conversion" überflüssig.

Das mindestens eine Übertragungsglied sollte hierzu eine Kennlinie aufweisen, die zumindest teilweise der Kennlinie der Verzerrung des Leistungsverstärkers angepasst ist. Die "AM PM conversion" bzw. die Signalverzerrungscharakteristik des Leistungsverstärkers weist in der Regel einen nichtlinearen Verlauf auf. Wird diese "AM PM conversion" bzw. Signalverzerrungscharakteristik exakt durch die Kennlinie des Übertragungsgliedes berücksichtigt, erfolgt eine vollständige Unterdrückung der "AM PM conversion" bzw. der Signalverzerrung. In guter Näherung kann dieser nichtlineare Verlauf mathematisch durch eine Potenzreihe $\phi_e = \sum_{i=1}^{n} \phi_{ei} \cdot A_1^{\ i}$ angenähert werden, mit

$\phi_e$ = Phasendifferenz aufgrund der "AM PM conversion",
i = Summationsindex von 1 bis n,
$\phi_{ei}$ = Entwicklungsglied,
$A_1$ = Amplitudensteuersignal.

Für eine gute Signalunterdrückung ist es ausreichend, das erste Glied dieser Potenzreihe bei der Erstellung der Kennlinie des Übertragungsgliedes zu berücksichtigen.

Als Übertragungsglied ist beispielsweise ein Verstärker geeignet. Der Verstärker gewichtet das Amplitudensteuersignal des Amplitudenregelkreises mit einem konstanten Faktor, wodurch eine Korrektur der "AM PM conversion" in erster Ordnung erreicht wird.

Im Phasenregelkreis wird ein steuerbarer Phasenschieber angeordnet, mit dem das Korrektursignal in den Phasenregelkreis eingespeist wird. Hierdurch können Phasenverschiebungen der modulierten Signale zwischen Amplitudenregelkreis und Phasenregelkreis kompensiert werden.

Weiterhin vorteilhaft ist es, wenn im Phasenregelkreis ein Oszillator angeordnet ist und das Korrektursignal mit der Steuerspannung des Oszillators verbunden ist. Das Korrektursignal wird zur Steuerspannung des Oszillators addiert. Wenn das Korrektursignal aus dem differenzierten Amplitudensteuersignal gebildet wird, so bedeutet dies die vollständige Unterdrückung der "AM PM conversion" erster Ordnung.

Wird dem Übertragungsglied ein Multiplikator mit nachgeschaltetem Integratorglied zugeschaltet, so kann das Übertragungsglied dynamisch an die momentane Charakteristik der "AM PM conversion" angepasst werden. Mit dieser besonderen Ausführung der Schaltungsanordnung kann die Korrelation der Steuersignale des Phasenregelkreises und des Amplitudenregelkreises bestimmt werden.

Entsprechend der neuen "Polar Loop"-Schaltungsanordnung schlägt der Erfinder auch ein Verfahren zur Erzeugung und Verstärkung von amplituden- und phasenmodulierten Signalen in einer "Polar Loop"-Schaltungsanordnung vor, bei dem mittels Amplituden- und Phasenregelkreis eine nach Amplitude und Phase getrennte Signalmodulation vorgenommen wird und die Modulationssignale danach in den Eingang eines Leistungsverstärkers eingespeist werden und im Leistungsverstärker die Signale verstärkt werden, wobei zwischen Eingang und Ausgang des Leistungsverstärkers Signalverzerrungen, insbesondere in Form von "AM PM conversion", auftreten, die teilweise von den Regelkreisen selbst reduziert werden. Das neue Verfahren zeichnet sich dadurch aus, dass zur weiteren Reduzierung von Signalverzerrungen aus dem Amplitudenregelkreis ein Korrektursignal abgeleitet wird und in den Phasenregelkreis einspeist wird.

In den Leistungsverstärker werden an die Signalverzerrungscharakteristik des Leistungsverstärkers angepasste korrigierte Signale eingespeist werden, so dass am Ausgang des Leistungsverstärkers unverzerrte verstärkte Signale zur Verfügung stehen.

Für das Verfahren ist es vorteilhaft, wenn eine Übertragungsfunktion hergeleitet wird, die zumindest teilweise der Verzerrungscharakteristik des Leistungsverstärkers entspricht. Durch die teilweise Anpassung der Übertragungsfunktion an die Verzerrungscharakteristik des Leistungsverstärkers wird bereits eine deutliche Reduzierung der Signalverzerrung über die mögliche Reduzierung durch die Regelkreise hinaus erreicht.

Die Verzerrungscharakteristik des Leistungsverstärkers kann durch eine Potenzreihe modelliert werden, bei der sich für die "AM PM conversion" $\phi_e = \sum_{i=1}^{n} \phi_{ei} \cdot A_1^{i}$ ergibt,

wobei die Elemente

$\phi_e$ = Phasendifferenz aufgrund der "AM PM conversion",
i = Summationsindex von 1 bis n,
$\phi_{ei}$ = Entwicklungsglied,
$A_1$ = Amplitudensteuersignal,

bedeuten.

Durch die Annäherung der Verzerrungscharakteristik des Leistungsverstärkers durch eine Potenzreihe ist es möglich, je nach Berücksichtigung der Anzahl der Potenzglieder den Anteil der Unterdrückung der Verzerrung zu erhöhen.

Bereits eine erhebliche Reduzierung der Signalverzerrung lässt sich dadurch erreichen, wenn das Korrekturglied in erster Ordnung für i = 1 angenähert wird.

In einer Ausführung des Verfahrens ist es vorgesehen, das Korrektursignal unter Verwendung digitaler (Halbleiter-) Bauelemente zwischen Amplituden- und Phasenregelkreis zu übertragen.

Eine einfache Ausführung des Verfahrens sieht vor, dass ein Amplitudensteuersignal des Amplitudenregelkreises mit einem konstanten Faktor gewichtet und zwischen Amplituden- und Phasenregelkreis übertragen wird. Eine einfache Gewichtung mit einem konstanten Faktor lässt sich mit geringem Bauteileaufwand realisieren, beispielsweise mit einem einfachen Verstärker.

Im Phasenregelkreis kann ein steuerbarer Phasenschieber die Phase im Phasenregelkreis korrigieren.

Es ergeben sich weitere Vorteile, wenn das Korrektursignal die Steuerspannung des Oszillators im Phasenregelkreis beeinflusst. Das Korrektursignal kann beispielsweise zur Steuerspannung des Oszillators hinzu addiert werden. Damit beschränkt sich der Schaltungsaufwand auf ein Skalierungsglied und ein Summierglied.

Es ist weiterhin von Vorteil, wenn zur Bestimmung der Korrelation zwischen Phasensteuersignal und Amplitudensteuersignal ein Multiplikator mit nachgeschaltetem Integratorglied verwendet wird. Hierdurch kann die Anpassung des Übertragungsgliedes an die momentane "AM PM conversion" besser gewährleistet werden. Beispielsweise können hierdurch Änderungen der Verzerrungscharakteristik, zum Beispiel aufgrund von Temperaturschwankungen und damit einhergehende Schwankungen der Werte der (Halbleiter-) Bauelemente, schnell und dynamisch ausgeglichen werden.

Zusätzliche Merkmale und Vorteile der Erfindung ergeben sich aus der nachfolgenden Beschreibung bevorzugter Ausführungsbeispiele unter Bezugnahme auf die Zeichnung.

Die Erfindung soll nachfolgend anhand der Zeichnungen 1 bis 5 näher erläutert werden, wobei in den Zeichnungen nur die für die Erfindung wesentliche Komponenten dargestellt sind. Hierbei werden die folgenden Bezugszeichen verwendet: 1: "Polar Loop"-Schaltungsanordnung; 1.1: Phasenregelkreis; 1.2: Amplitudenregelkreis; 2.1: Integratorglied eins; 2.2: Integratorglied zwei; 2.3: Integratorglied drei; 2.4: Integratorglied vier; 3: Oszillator; 4: Leistungsverstärker; 4.1: Eingang des Leistungsverstärkers für den Phasenanteil der Signale; 4.2: Eingang des Leistungsverstärkers für den Amplitudenanteil der Signale; 4.3: Ausgang des Leistungsverstärkers für den Phasenanteil der Signale; 4.4: Ausgang des Leistungsverstärkers für den Amplitudenanteil der Signale; 5: Amplitudensteuerkennlinie; 6: Kennlinie der "AM PM conversion"; 7: Summierglied / Phasenschieber; 8: Phasenvergleicher; 9: Amplitudenvergleicher; 10: Übertragungsglied; 11: Korrektursignal; 12: Multiplikator; 13: Gewichtungsfaktor; $A_s$: Amplitudenanteil; A: verstärkte Amplitude; $A_1$: erste Amplitudensteuergröße; $A_2$: zweite Amplitudensteuergröße; $\Phi_e$: Phasendifferenz; $\Phi_s$ : Phasenanteil; $\Phi_x$: Fehlerhaftes Phasensignal; $\Phi$: korrigiertes Phasensignal.

Es stellen dar:

Figur 1: Bekannte "Polar Loop"-Schaltungsanordnung;
Figur 2: "Polar Loop"-Schaltungsanordnung mit Element zur Korrektur der "AM PM conversion";
Figur 3: "Polar Loop"-Schaltungsanordnung mit Korrektur des Anteils erster Ordnung der "AM PM conversion" durch einen Multiplikator;
Figur 4: Abgewandelte "Polar Loop"-Schaltungsanordnung aus Figur 3;
Figur 5: "Polar Loop"-Schaltungsanordnung mit automatischer Korrektur der "AM PM conversion" erster Ordnung.

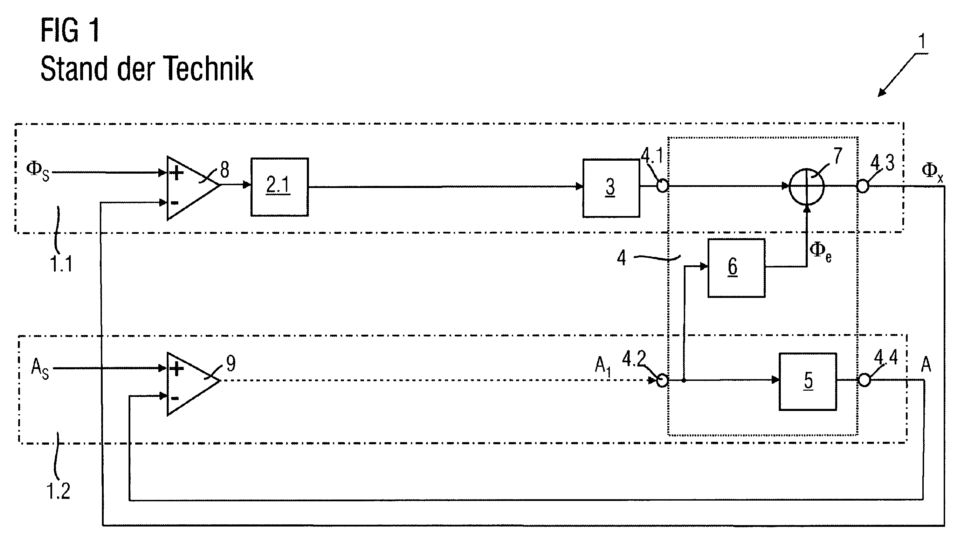

Die **Figur 1** zeigt eine bekannte "Polar Loop"-Schaltungsanordnung 1, wie sie zur Erzeugung und Verstärkung von amplituden- und phasenmodulierten Hochfrequenzsignalen, zum Beispiel von Signalen eines Mobilfunkendgerätes, verwendet wird.

Die Signalverstärkung findet im Leistungsverstärker 4 statt, wobei die Signale nach Amplitude und Phase getrennt an den Eingängen 4.1 und 4.2 des Leistungsverstärkers 4 eingespeist werden und an den Ausgängen 4.3 und 4.4 des Leistungsverstärkers 4 als verstärktes Phasensignal $\Phi_x$, welches mit einen Phasenfehler behaftet ist, und als verstärktes Amplitudensignal A ausgegeben werden.

Dieser Phasenfehler des Phasensignal $\Phi_x$ tritt in dieser Schaltungsanordnung aufgrund einer Signalverzerrung auf, die als "AM PM conversion" bekannt ist und in Figur 1 mit dem Bezugszeichen 6 bezeichnet ist. Zwischen dem Eingang 4.1, 4.2 und dem Ausgang 4.3, 4.4 des Leistungsverstärkers 4, wobei der Eingang 4.1 und der Ausgang 4.3 für die Phasenanteile und der Eingang 4.2 und der Ausgang 4.4 für die Amplitudenanteile der Signale zuständig sind, kommt es zu einer Phasendifferenz $\Phi_e$. Diese Phasendifferenz $\Phi_e$ ist abhängig von der ersten Amplitudensteuergröße $A_1$ und lässt sich mathematisch als Funktion der Amplitude ausdrücken:

$$\Phi_e = f(A_1) \qquad\qquad \text{(Gleichung 1)}$$

Zur Phasen- und Amplitudenmodulation wird der Phasenanteil $\Phi_s$ und der Amplitudenanteil $A_s$ der Signale getrennt voneinander behandelt und dann im Leistungsverstärker 4 zusammengeführt und verstärkt. Der Bereich, der durch eine abwechselnd gepunktete und gestrichelte Linie eingerahmt ist, oben in Figur 1, stellt den Phasenregelkreis 1.1 dar. Der Bereich, der durch eine abwechselnd gepunktete und gestrichelte Linie eingerahmt ist, unten in Figur 1, stellt den Amplitudenregelkreis 1.2 dar.

Im Phasenregelkreis 1.1 wird der Phasenanteil $\Phi_s$ der Signale zunächst in einem Phasenvergleicher 8 mit der Phase des fehlerhaften Phasensignals $\Phi_x$ aus dem Ausgang 4.3 des Leistungsverstärkers 4 verglichen. Nach dem Phasenvergleich wird das Signal durch ein Integratorglied 2.1 integriert und mit dem Integratorglied 2.1 ein Oszillator 3 in der Frequenz moduliert. Es ist üblich in einem Regelkreis im allgemeinen einen Integrator zu verwenden, um die vollständige Ausregelung von statischen Störungen herbeizuführen. Danach wird das so phasenmodulierte Signal am Eingang 4.1 des Leistungsverstärkers 4 eingespeist und verstärkt.

Im Amplitudenregelkreis 1.2 wird der Amplitudenanteil $A_s$ in einem Amplitudenvergleicher 9 mit der Amplitude des verstärkten Ausgangssignals A vom Ausgang 4.4 des Leistungsverstärkers 4 verglichen und der Amplitudenfehler nach einer Weiterverarbeitung zur Amplitudensteuerung in den Eingang 4.2 des Leistungsverstärkers 4 eingespeist.

Durch die Signalverzerrung beziehungsweise die "AM PM conversion" 6 wird im Phasenregelkreis 1.1 diese Phasendifferenz $\Phi_e$ dem Phasensignal durch das Summierglied 7 hinzu addiert. Die hinzugefügte Phasendifferenz $\Phi_e$ erzeugt ein fehlerhaftes Phasensignal $\Phi_x$, das mathematisch wie folgt ausgedrückt werden kann:

$$\Phi_x(s) = \Phi_e(s) \cdot \frac{1}{1 + H_1(s) \cdot \dfrac{K_1}{s}} \qquad\qquad \text{(Gleichung 2),}$$

wobei die Faktoren $H_1$ und $K_1$ für Einflussgrößen des Integratorglieds 2.1 und des Oszillators 3 stehen.

Dieses fehlerhafte Phasensignal $\Phi_x$ gilt es nun zu minimieren. Bisher musste hierzu der Phasenregelkreis 1.1 eine möglichst hohe Regelverstärkung aufweisen beziehungsweise eine möglichst hohe Bandbreite besitzen. Hierdurch konnte der Effekt der "AM PM conversion" 6 prinzipiell verringert werden, wobei gleichzeitig andere Parameter, wie Regelkreisstabilität und Rauscheigenschaften, äußert negativ beeinflusst wurden. Die Eingangs erwähnten aufwendigen Kompensationsschaltungen sind in Figur 1 nicht dargestellt.

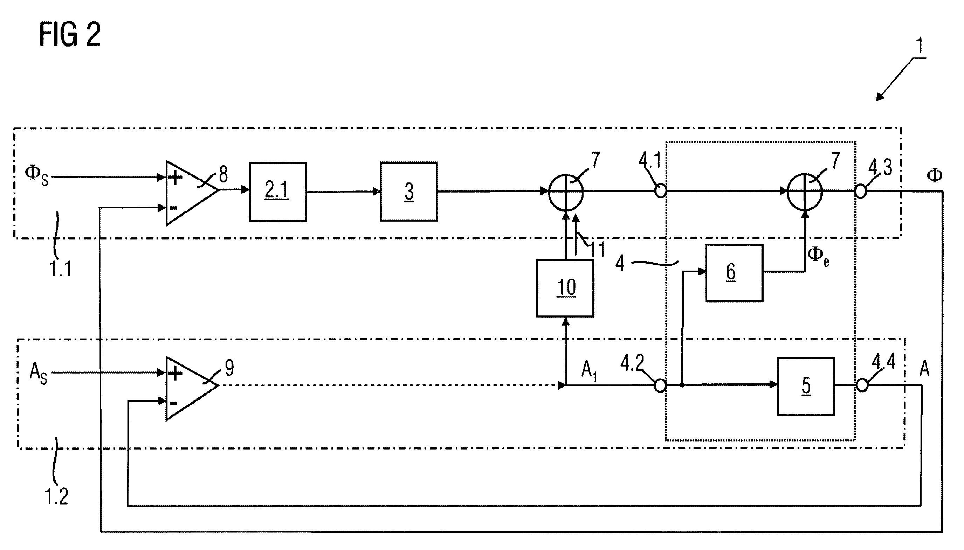

In den Figuren 2 bis 5 werden nachfolgend einfache Schaltungsanordnungen erläutert, mit denen die "AM PM conversion" 6 bzw. das fehlerhafte Phasensignal $\Phi_x$ zumindest verringert oder ganz beseitigt werden können.

Die **Figur 2** zeigt im wesentlichen die bekannte "Polar Loop"-Schaltungsanordnung 1 aus Figur 1, wie sie zur Erzeugung und Verstärkung von amplituden- und phasenmodulierten Hochfrequenzsignalen eingesetzt wird. Um nun das durch die "AM PM conversion" 6 hervorgerufene fehlerhafte Phasensignal ($\Phi_x$ aus Figur 1) am Ausgang 4.3 des Leistungsverstärkers 4 im Phasenregelkreis 1.1 zu unterdrücken wird zwischen Amplitudenregelkreis 1.2 und Phasenregelkreis 1.1 ein Übertragungsglied 10 eingesetzt, welches aus dem Amplitudenregelkreis 1.2 ein Korrektursignal 11 ableitet, welches die Phase korrigiert, und in den Phasenregelkreis 1.1 einspeist. Die Einspeisung erfolgt über ein Summierglied 7 vor der Verstärkung des Phasenanteils der Signale im Leistungsverstärker 4.

Das fehlerhafte Phasensignal ($\Phi_x$ aus Figur 1), welches durch die Gleichung 2 beschrieben wird, wird dann Null, wenn für das Korrektursignal 11 folgendes Beziehung gilt:

$$m(A_1) = -\Phi_e(A_1) + m_0 \qquad \text{(Gleichung 3)},$$

wobei $A_1$ in Gleichung 3 die erste Amplitudensteuergröße ist.

Ein konstanter Phasenanteil $m_0$ in Gleichung 3 wird durch den integrierenden Charakter des Phasenregelkreises 1.1 vollständig unterdrückt und bewirkt deshalb ein fehlerfreies Phasensignal $\Phi$ am Ausgangs 4.3 des Leistungsverstärkers 4.

Um das durch die "AM PM conversion" 6 erzeugte fehlerhafte Phasensignal ($\Phi_x$ aus Figur 1) vollständig auszulöschen, muss das Übertragungsglied 10, gemäß Gleichung 3, genau der Kennlinie der Verzerrung des Leistungsverstärkers 4 angepasst sein.

In der praktischen Anwendung ist es ausreichend, eine vereinfachte Kennlinie für das Übertragungsglied 10 zu benutzen. Die nichtlineare "AM PM conversion" 6 lässt sich mathematisch als Potenzreihe annähern:

$$\Phi_e = \Phi_{e1} \cdot A_1 + \Phi_{e2} \cdot A_1^2 + \Phi_{e3} \cdot A_1^3 + \dots + \Phi_{en} \cdot A_1^n \qquad \text{(Gleichung 4)}$$

Zur Korrektur der "AM PM conversion" 6 erster Ordnung genügt es, wenn in Gleichung 4 der erste Summand, also der Term: $\Phi_{e1} \cdot A_1$, zu Null wird.

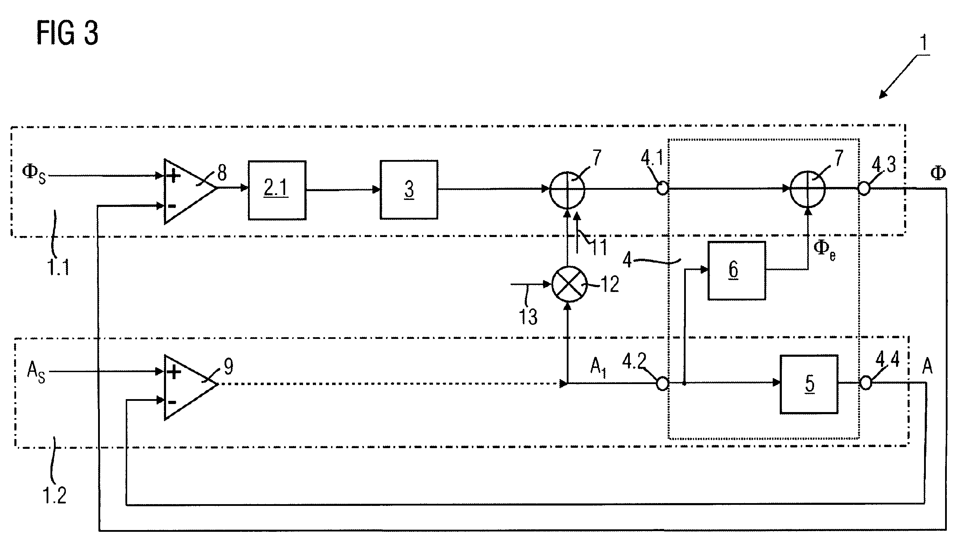

In **Figur 3** wird hierzu ein besonderes Übertragungsglied zwischen Amplitudenregelkreis 1.2 und Phasenregelkreis 1.1 eingesetzt, nämlich ein Multiplikator 12. Der Multiplikator 12 multipliziert das erste Amplitudensteuersignal $A_1$ des Amplitudenregelkreises 1.2 mit einem konstanten Gewichtungsfaktor 13. Wird ein in der Phase derartig korrigiertes Signal in den Eingang 4.1 des Leistungsverstärkers 4 eingespeist, so wird das Phasensignal $\Phi$ am Ausgang 4.3 des Leistungsverstärkers 4 nahezu unverzerrt ausgegeben.

In der Realisierung einer "Polar Loop"-Schaltungsanordnung ist die Addition eines (Phasen-)Korrektursignals 11 mit einem Summierglied 7 zum Phasenregelkreis 1.1, wie in den Figuren 2 und 3 dargestellt, nur bedingt möglich, da das Summierglied 7 in der Regel einem steuerbaren Phasenschieber entspricht. Solche Bauteile sind aufwendig und können unerwünschte Nebeneffekte bewirken.

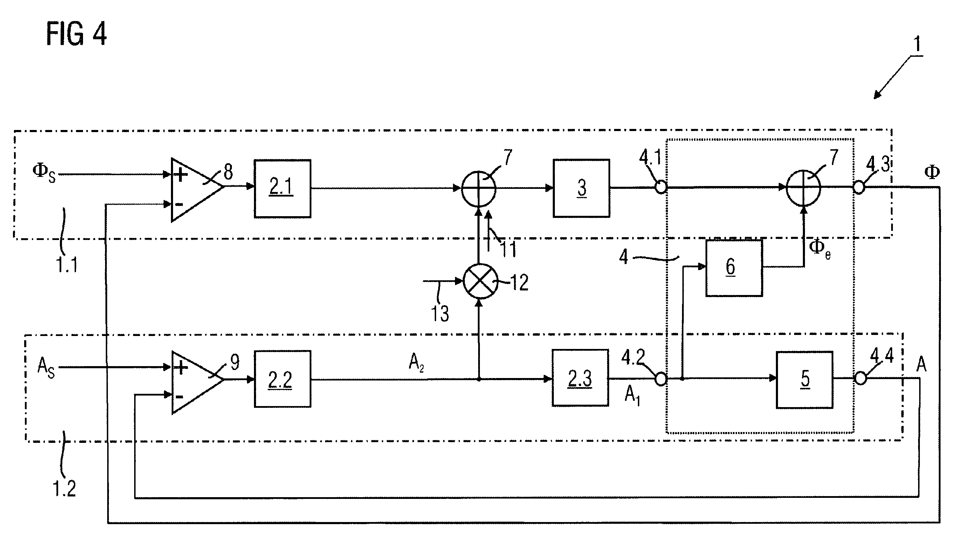

Um diese Nebeneffekte zu verhindern, wird in **Figur 4** eine verbesserte "Polar Loop"-Schaltungsanordnung 1 dargestellt, die die "AM PM conversion" 6 erster Ordnung kompensiert.

Das aus dem Amplitudenregelkreis 1.2 abgeleitete Korrektursignal 11 wird zur Steuerspannung des Oszillators 3 mit einem Summierglied 7 hinzu addiert. Wenn das Korrektursignal 11 aus der differenzierten zweiten Amplitudensteuergröße $A_2$ gebildet wird, so bedeutet dies die vollständige Unterdrückung der "AM PM conversion" 6 in erster Ordnung:

$$K_1 \int A_2(t) G \cdot dt + K_2 \int A_2(t) \Phi_{e1} \cdot dt = \text{const} \qquad \text{(Gleichung 5)}.$$

Hieraus ergibt sich für den Gewichtungsfaktor 13:

$$G = -\Phi_{e1} \frac{K_2}{K_1} \qquad \text{(Gleichung 6)},$$

wobei die Faktoren $K_1$ und $K_2$ für Einflussgrößen der Integratorglieder 2.1 und 2.2 stehen.

Da in der Realisierung der "Polar Loop"-Schaltungsanordnung die differenzierte zweite Amplitudensteuergröße $A_2$, auf Grund des erforderlichen dritten Integratorglieds 3.3 ohnehin vorliegt, kann dieses Signal nach einfachem Skalieren gemäß der Gleichung 6 zur Steuerspannung des Oszillators 3 addiert werden. Damit beschränkt sich der Schaltungsaufwand auf ein Skalierungsglied und ein Summierglied 11.

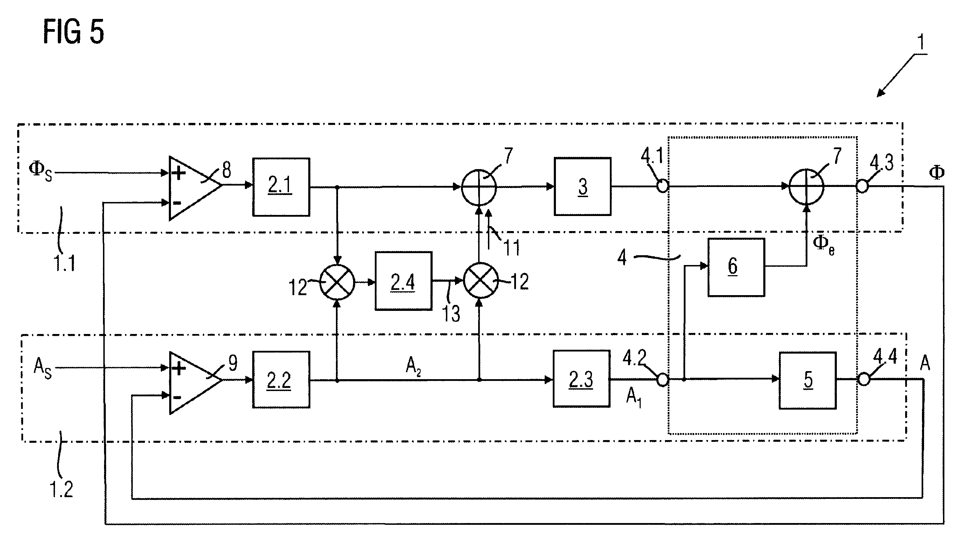

In **Figur 5** wird eine "Polar Loop"-Schaltungsanordnung 1 dargestellt, die die "AM PM conversion" 6 erster Ordnung automatisch kompensiert. Hierzu wird ebenfalls als Übertragungsglied ein Multiplikator 12 genutzt. Um eine automatische bzw. dynamische Anpassung an die momentane Charakteristik der "AM PM conversion" 6 zu ermöglichen, wird ein weiterer Multiplikator 12 mit nachgeschaltetem Integratorglied 2.4 eingesetzt, um die Korrelation des Phasensteuersignals mit dem Amplitudensteuersignal zu bestimmen. Während das ideale Nutzsignal von digitalen Modulationsverfahren wie GSM EDGE im zeitlichen Mittel keine Korrelation zwischen Phasenänderung und Amplitudenänderung aufweist, wird durch "AM PM conversion" 6 eine solche Korrelation in der "Polar Loop"-Schaltungsanordnung sichtbar. Mit einem Regler kann die Verstärkung des Übertragungsgliedes so nachgeführt werden, dass die Korrelation minimal bleibt.

Ergänzend bzw. alternativ zu den Ausführungen in den Figuren 2 bis 5 kann auch eine digitale Regelung eingesetzt werden, welche die Realisierung komplexerer Regelcharakteristiken erlaubt. Hierdurch ist eine adaptive Kompensation der "AM PM conversion" denkbar.

Schließlich kann die Einspeisung des Korrektursignals 11 auch an anderen Knoten im Vorwärtspfad des Phasenregelkreises 1.1 erfolgen, wenn die Gewinnung des Korrektursignals aus dem Amplitudenregelkreis 1.2 ebenfalls geeignet modifiziert wird.

Es versteht sich, dass die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird also durch die Erfindung eine "Polar Loop"-Schaltungsanordnung und ein Verfahren zur Unterdrückung von Signalverzerrungen, wie sie durch die PA Eigenschaft der "AM PM conversion" erzeugt werden, zur Verfügung gestellt, die mit geringerem Bauteileaufwand und somit geringeren Kosten realisierbar sind.

## Patentansprüche

1. "Polar Loop"-Schaltungsanordnung (1) zur Erzeugung und Verstärkung von amplituden- und phasenmodulierten Signalen ((Φ, A) mit mindestens: einem Leistungsverstärker (4), einem Amplituden- und einem Phasenregelkreis (1.1, 1.2), wobei mittels Amplituden- und Phasenregelkreis (1.1, 1.2) eine nach Amplitude und Phase getrennte Signalmodulation stattfindet und die Modulationssignale ($\Phi_s$, $A_s$) zur Signalverstärkung dem Eingang (4.1, 4.2) des Leistungsverstärkers (4) zugeführt werden und zwischen Eingang (4.1, 4.2) und Ausgang (4.3, 4.4) des Leistungsverstärkers (4) Signalverzerrungen, insbesondere in Form von "AM PM conversion" (6), auftreten, die innerhalb einer Regelbandbreite von den Regelkreisen (1.1, 1.2) reduziert werden, **dadurch gekennzeichnet, dass** zur weiteren Reduzierung von Signalverzerrungen vor dem Eingang (4.1, 4.2) des Leistungsverstärkers (4) und zwischen Amplitudenregelkreis (1.2) und Phasenregelkreis (1.1) zumindest ein Übertragungsglied (10, 12) angeordnet ist, das aus dem Amplitudenregelkreis (1.2) ein Korrektursignal (11) ableitet und in den Phasenregelkreis (1.1) einspeist.

2. Schaltungsanordnung gemäß dem voranstehenden Patentanspruch 1, **dadurch gekennzeichnet, dass** das mindestens eine Übertragungsglied (10, 12) eine Kennlinie aufweist, die zumindest teilweise der Kennlinie der Verzerrung des Leistungsverstärkers (4) angepasst ist.

3. Schaltungsanordnung gemäß einem der voranstehenden Patentansprüche 1 und 2, **dadurch gekennzeichnet, dass** das mindestens eine Übertragungsglied ein Multiplikator (12) ist.

4. Schaltungsanordnung gemäß einem der voranstehenden Patentansprüche 1 bis 3, **dadurch gekennzeichnet, dass** im Phasenregelkreis (1.1) ein steuerbarer Phasenschieber (7) angeordnet ist, mit dem das Korrektursignal (11) in den Phasenregelkreis (1.1) eingespeist wird.

5. Schaltungsanordnung gemäß einem der voranstehenden Patentansprüche 1 bis 4, **dadurch gekennzeichnet, dass** im Phasenregelkreis (1.1) ein Oszillator (3) angeordnet ist und das Korrektursignal (11) mit der Steuerspannung des Oszillators (3) verbunden ist.

6. Schaltungsanordnung gemäß einem der voranstehenden Patentansprüche 1 bis 5, **dadurch gekennzeichnet, dass** dem Übertragungsglied ein Multiplikator (12) mit nachgeschaltetem Integratorglied (2.4) zugeschaltet ist.

7. Verfahren zur Erzeugung und Verstärkung von amplituden- und phasenmodulierten Signalen in einer "Polar Loop"-Schaltungsanordnung (1), bei dem mittels Amplituden- und Phasenregelkreis (1.1, 1.2) eine nach Amplitude und Phase getrennte Signalmodulation vorgenommen wird und die Modulationssignale danach in den Eingang (4.1, 4.2) eines Leistungsverstärkers (4) eingespeist werden und im Leistungsverstärker (4) die Signale verstärkt werden, wobei zwischen Eingang (4.1, 4.2) und Ausgang (4.3, 4.4) des Leistungsverstärkers (4) Signalverzerrungen, insbesondere in Form von "AM PM conversion" (6), auftreten, die teilweise von den Regelkreisen (1.1, 1.2) selbst reduziert werden, **dadurch gekennzeichnet, dass** zur weiteren Reduzierung von Signalverzerrungen aus dem Amplitudenregelkreis (1.2) ein Korrektursignal (11) abgeleitet wird und in den Phasenregelkreis (1.1) eingespeist wird.

8. Verfahren gemäß dem voranstehenden Patentanspruch 7, **dadurch gekennzeichnet, dass** eine Übertragungsfunktion hergeleitet wird, die zumindest teilweise der Verzerrungscharakteristik des Leistungsverstärkers (4) entspricht.

9. Verfahren gemäß einem der voranstehenden Patentansprüche 7 und 8, **dadurch gekennzeichnet, dass** die Verzerrungscharakteristik des Leistungsverstärkers durch eine Potenzreihe modelliert wird, bei der sich für die "AM PM conversion" $\phi_e = \sum_{i=1}^{n} \phi_{ei} \cdot A_1^{i}$ ergibt,

wobei

$\phi_e$ = Phasendifferenz aufgrund der "AM PM conversion",
i = Summationsindex von 1 bis n,
$\phi_{ei}$ = Entwicklungsglied,
$A_1$ = Amplitudensteuergröße

bedeuten.

10. Verfahren gemäß dem voranstehenden Patentanspruch 9, **dadurch gekennzeichnet, dass** zur Reduzierung der Signalverzerrung das Korrekturglied in erster Ordnung für i = 1 angenähert wird.

11. Verfahren gemäß einem der voranstehenden Patentansprüche 7 bis 10, **dadurch gekennzeichnet, dass** das Korrektursignal (11) unter Verwendung digitaler Bauelemente zwischen Amplituden- und Phasenregelkreis (1.1, 1.2) übertragen wird.

12. Verfahren gemäß einem der voranstehenden Patentansprüche 7 bis 11, **dadurch gekennzeichnet, dass** eine Amplitudensteuergröße ($A_1$, $A_2$) des Amplitudenregelkreises (1.2) mit einem konstanten Faktor (13) gewichtet wird und zwischen Amplituden- und Phasenregelkreis (1.1, 1.2) übertragen wird.

13. Verfahren gemäß einem der voranstehenden Patentansprüche 7 bis 12, **dadurch gekennzeichnet, dass** im Phasenregelkreis (1.1) ein steuerbarer Phasenschieber (7) die Phase korrigiert.

14. Verfahren gemäß einem der voranstehenden Patentansprüche 7 bis 13, **dadurch gekennzeichnet, dass** das Korrektursignal (11) der Steuerspannung des Oszillators (3) im Phasenregelkreis (1.1) zugeführt wird.

15. Verfahren gemäß einem der voranstehenden Patentansprüche 7 bis 14, **dadurch gekennzeichnet, dass** zur Bestimmung der Korrelation zwischen Phasensteuersignal und Amplitudensteuersignal ein Multiplikator (12) mit nachgeschaltetem Integratorglied (2.4) verwendet wird.

## Claims

1. "Polar Loop"-circuitry (1) for generation and amplification of amplitude modulated and phase modulated signals (Φ, A), the circuitry comprising at least: a power amplifier (4), an amplitude and a phase control circuit (1.1, 1.2), wherein a signal modulation is carried out by means of the amplitude and phase control circuits (1.1, 1.2) in a manner separated for amplitude and phase and wherein the modulation signals ($\Phi_s$, $A_s$) are supplied to the input (4.1, 4.2) of the power amplifier (4) and wherein signal distortions, particularly in form of "AM PM conversion" (6), occur between the input (4.1, 4.2) and the output (4.3, 4.4) of the power amplifier (4), which signal distortions been reduced within a control bandwidth of the control circuits (1.1, 1.2), **characterized in that**, for a further reduction of signal distortions, at least one transmission element (10, 12) is arranged in front of the input (4.1, 4.2) of the power amplifier (4) and between the amplitude control circuit (1.2) and the phase control circuit (1.1), which at least one transmission element derives a correction signal (11) from the amplitude control circuit (1.2) and supplies the correction signal into the phase control circuit (1.1).

**2.** Circuitry according to the proceeding claim 1, **characterized in that** the at least one transmission element (10, 12) has a characteristic curve, which is at least partially matched with the characteristic curve of the distortion of the power amplifier (4).

**3.** Circuitry according to one of the proceeding claims 1 and 2, **characterized in that** the at least one transmission element is a multiplier (12).

**4.** Circuitry according to one of the proceeding claims 1 to 3, **characterized in that** a controllable phase shifter (7) is arranged in the phase control circuit (1.1) by means of which controllable phase shifter (7) the correction signal (11) is supplied into the phase control circuit (1.1).

**5.** Circuitry according to one of the proceeding claims 1 to 4, **characterized in that** an oscillator (3) is arranged in the phase control circuit (1.1) and the correction signal (11) is coupled to the control voltage of the oscillator (3).

**6.** Circuitry according to one of the proceeding claims 1 to 5, **characterized in that** a multiplier (12) having a integrator element (2.4) being coupled downstream therewith is switched on the transmission element.

**7.** Method for generating and amplifying of amplitude modulated and phase modulated signals in a "Polar Loop"-circuitry (1), in which by means of amplitude and phase control circuits (1.1, 1.2) a signal modulation is carried out in a manner separated for amplitude and phase and wherein the modulation signals are supplied to the input (4.1, 4.2) of a power amplifier (4) and wherein the signals are amplified in the power amplifier (4), wherein signal distortions, particularly in form of "AM PM conversion" (6), occur between the input (4.1, 4.2) and the output (4.3, 4.4) of the power amplifier (4), which signal distortions being at least partially reduced by the control circuits (1.1, 1.2) themselves, **characterized in that**, for a further reduction of signal distortions, a correction signal (11) is derived from the amplitude control circuit (1.2) and supplied into the phase control circuit (1.1).

**8.** Method according to the proceeding claim 7, **characterized in that** a transfer function is derived, which at least partially corresponds with the distortion characteristic of the power amplifier (4).

**9.** Method according to one of the proceeding claims 7 and 8, **characterized in that** the distortion characteristic of the power amplifier is modeled by a power series, in which the "AM PM conversion" results in

$$\Phi_e = \sum_{i=1}^{n} \Phi_{ei} \cdot A_1^i$$

wherein indicates

$\Phi_e$ = phase difference due to the "AM PM conversion",
i = summation index from 1 to n,
$\Phi_{ei}$ = expansion term,
$A_1$ = amplitude control quantity.

**10.** Method according to the proceeding claim 9, **characterized in that** the correction term of the first order is approximated for i = 1 for reducing the signal distortion.

**11.** Method according to one of the proceeding claims 7 to 10, **characterized in that** the correction signal (11) is transmitted between the amplitude and phase control circuits (1.1, 1.2) by means of digital components.

**12.** Method according to one of the proceeding claims 7 to 11, **characterized in that** an amplitude control quantity ($A_1$, $A_2$) of the amplitude control circuit (1.2) is weighted with a constant factor (13) and is transmitted between the amplitude and phase control circuits (1.1, 1.2).

**13.** Method according to one of the proceeding claims 7 to 12, **characterized in that** a controllable phase shifter (7) controls the phase in the phase control circuit (1.1).

**14.** Method according to one of the proceeding claims 7 to 13, **characterized in that** the correction signal (11) is supplied to the control voltage of the oscillator (3) in the phase control circuit (1.1).

**15.** Method according to one of the proceeding claims 7 to 14, **characterized in that** a multiplier (12) having a integrator element (2.4) being coupled downstream therewith is used for determination of the correlation between the phase control signal and the amplitude control signal.

**Revendications**

**1.** Ensemble de circuits en « boucle polaire » (1) pour la génération et l'amplification de signaux modulés en amplitude et en phase (Φ, A), avec au moins un amplificateur de puissance (4), un circuit de régulation d'amplitude et de phase (1.1, 1.2), une modulation de signal séparée en amplitude et en phase étant effectuée au moyen du circuit de régulation d'amplitude et de phase (1,1, 1.2) et les signaux de modulation ($\Phi_s$, $A_s$) étant conduits vers l'entrée (4.1, 4.2) de l'amplificateur de puissance (4) pour une amplification de signal, et des distorsions de signal, notamment sous la forme de « conversion AM PM » (6), apparaissant entre l'entrée (4.1, 4.2) et la sortie (4.3, 4.4) de l'amplificateur de puissance (4), lesquelles sont réduites par les circuits de régulation (1.1, 1.2) à l'intérieur d'une largeur de bande de régulation, **caractérisé en ce que**, pour une réduction complémentaire des distorsions de signal avant l'entrée (4.1, 4.2) de l'amplificateur de puissance (4) et **en ce qu'**au moins un élément de transmission (10, 12) est disposé entre le circuit de régulation d'amplitude (1.2) et le circuit de régulation de phase (1.1), lequel déduit un signal de correction (11) du circuit de régulation d'amplitude (1.2) et délivre celui-ci au circuit de régulation de phase (1.1).

**2.** Ensemble de circuits selon la revendication 1, **caractérisé en ce que** le ou les éléments de transmission (10, 12) présentent une courbe caractéristique au moins partiellement ajustée à la courbe caractéristique de la distorsion de l'amplificateur de puissance (4).

**3.** Ensemble de circuits selon la revendication 1 ou 2, **caractérisé en ce que** le ou les éléments de transmission sont des multiplicateurs (12).

**4.** Ensemble de circuits selon l'une des revendications 1 à 3, **caractérisé en ce qu'**un convertisseur de phase (7) apte à être commandé est disposé sur le circuit de régulation de phase (1.1), au moyen duquel le signal de correction (11) est délivré au circuit de régulation de phase (1.1).

**5.** Ensemble de circuits selon l'une des revendications 1 à 4, **caractérisé en ce qu'**un oscillateur (3) est disposé sur le circuit de régulation de phase (1.1), et **en ce que** le signal de correction (11) est relié à la tension de commande de l'oscillateur (3).

**6.** Ensemble de circuits selon l'une des revendications 1 à 5, **caractérisé en ce qu'**un multiplicateur (12) à élément intégrateur (2.4) consécutif est connecté à l'élément de transmission.

**7.** Procédé de génération et d'amplification de signaux modulés en amplitude et en phase dans un ensemble de circuits en « boucle polaire » (1), une modulation de signal séparée en amplitude et en phase étant effectuée au moyen du circuit de régulation d'amplitude et de phase (1.1, 1.2) et les signaux de modulation étant ensuite délivrés à l'entrée (4.1, 4.2) d'un amplificateur de puissance (4), les signaux étant amplifiés dans l'amplificateur de puissance (4), et des distorsions de signal, notamment sous la forme de « conversion AM PM » (6), apparaissant entre l'entrée (4.1, 4.2) et la sortie (4.3, 4.4) de l'amplificateur de puissance (4), lesquelles sont partiellement réduites par les circuits de régulation (1.1, 1.2) en tant que tels, **caractérisé en ce que**, pour une réduction complémentaire des distorsions du circuit de régulation d'amplitude (1.2), un signal de correction (11) est déduit et délivré au circuit de régulation de phase (1.1).

**8.** Procédé selon la revendication 7, **caractérisé en ce qu'**une fonction de transmission est dérivée, laquelle correspond au moins partiellement à la caractéristique de distorsion de l'amplificateur de puissance (4).

**9.** Procédé selon la revendication 7 ou 8, **caractérisé en ce que** la caractéristique de distorsion de l'amplificateur de puissance est modélisée par une série de puissance, où la « conversion AM PM » est donnée par $\phi_e = \sum_{i=1}^{n} \phi_{ei} \cdot A_1^i$

$\phi_e$ étant la différence de phase en raison de la « conversion AM PM »,

i, l'indice de sommation de 1 à n,

$\phi_{ei}$, le terme de développement

$A_1$, la valeur d'influence d'amplitude.

10. Procédé selon la revendication 9, **caractérisé en ce que**, pour la réduction de la distorsion de signal, le terme de correction est approché de i = 1 en première approximation.

11. Procédé selon l'une des revendications 7 à 10, **caractérisé en ce que** le signal de correction (11) est transmis entre le circuit de régulation d'amplitude et le circuit de régulation de phase (1.1, 1,2) en recourant à des composants numériques.

12. Procédé selon l'une des revendications 7 à 11, **caractérisé en ce qu'**une valeur d'influence d'amplitude ($A_1$, $A_2$) du circuit de régulation d'amplitude (1.2) est pondérée par un facteur constant (13) et transmise entre le circuit de régulation d'amplitude et le circuit de régulation de phase (1.1, 1.2).

13. Procédé selon l'une des revendications 7 à 12, **caractérisé en ce qu'**un convertisseur de phase (7) apte à être commandé corrige la phase dans le circuit de régulation de phase (1.1).

14. Procédé selon l'une des revendications 7 à 13, **caractérisé en ce que** le signal de correction (11) est conduit vers la tension de commande de l'oscillateur (3) dans le circuit de régulation de phase (1.1).

15. Procédé selon l'une des revendications 7 à 14, **caractérisé en ce qu'**il est recouru à un multiplicateur (12) à élément intégrateur (2.4) consécutif pour déterminer la corrélation entre le signal de commande de phase et le signal de commande d'amplitude.

FIG 1
Stand der Technik

FIG 2

$\Phi_S$

8
2.1
3
7
4.1
7
4.3
$\Phi$

1.1

11
4
6
$\Phi_e$

10

$A_S$
9
$A_1$
4.2
5
4.4
A

1.2

EP 1 797 638 B1

FIG 3

FIG 4

FIG 5

EP 1 797 638 B1

**EP 1 797 638 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0247249 A